# EUROPÄISCHE PATENTSCHRIFT

(11) **EP 2 340 608 B1**
(45) Veröffentlichungstag und Bekanntmachung des Hinweises auf die Patenterteilung: **12.06.2019**
(21) Anmeldenummer: 09744995.3
(22) Anmeldetag: 13.10.2009
(51) Int. Cl.: H02P 9/02, H02P 29/00

(54) **VORRICHTUNG UND VERFAHREN ZUR ÜBERWACHUNG UND/ODER ANALYSE VON ROTOREN VON ELEKTRISCHEN MASCHINEN IM BETRIEB**
DEVICE AND METHOD FOR MONITORING AND/OR ANALYZING ROTORS OF ELECTRIC MACHINES IN OPERATION
PROCÉDÉ ET DISPOSITIF DE SURVEILLANCE ET/OU D'ANALYSE DE ROTORS DE MACHINES ÉLECTRIQUES EN FONCTIONNEMENT

(30) Priorität: 22.10.2008 DE 102008043103
(43) Veröffentlichungstag der Anmeldung: 06.07.2011
(73) Patentinhaber: General Electric Technology GmbH, 5400 Baden (CH)
(72) Erfinder: HOBELSBERGER, Max, CH-5303 Würenlingen (CH); MARK, Bernhard, 79761 Waldshut (DE)
(74) Vertreter: General Electric Technology GmbH
(86) Internationale Anmeldenummer: PCT/EP2009/063332
(87) Internationale Veröffentlichungsnummer: WO 2010/046274

(56) Entgegenhaltungen:
- EP-A1- 1 936 393
- EP-A2- 1 427 082
- DE-A1- 2 108 670
- DE-A1-102005 050 486
- JP-A- S6 282 363
- JP-A- 11 083 686
- JP-A- 11 326 469
- JP-A- S57 148 528
- JP-A- S60 236 058
- KR-A- 20020 016 182
- US-A- 4 814 700
- US-A- 5 361 037
- US-A- 5 689 194
- US-A- 5 739 698
- US-A- 6 035 265
- US-B1- 6 459 276

## Beschreibung

### Technisches Gebiet der Erfindung

Die vorliegende Erfindung betrifft eine Vorrichtung und ein Verfahren zur Überwachung und/oder Analyse von Fehlerzuständen von elektrischen Maschinen im Betrieb. Die elektrische Maschine umfasst dabei wenigstens einen Generator mit Welle, ein Erregersystem sowie Antriebsmittel zum Antrieb dieser Welle. Es handelt sich dabei insbesondere um eine Vorrichtung für einen Einsatz in Kraftwerksanlagen.

### Stand der Technik

Elektrische Maschinen, insbesondere grosse elektrische Maschinen, wie sie in Kraftwerksanlagen eingesetzt werden, sollten, um einen reibungslosen Betrieb zu gewährleisten, kontinuierlich überwacht werden und/oder von Zeit zu Zeit analysiert werden, um Fehlerzustände rechtzeitig zu erkennen und unkontrollierte Ausfälle zu vermeiden.

WO 00/69062 offenbart ein System zur Überwachung einer Maschine, wobei das System bei Fehlerzuständen ein Warnsignalabgibt. Dabei umfasst das System mehrere Sensoren, welche verschiedene Parameter erfassen. So werden der Wellenerdungsstrom, die Wellenspannung, der Grad der Veränderung des Wellenerdungsstrom und der Grad der Veränderung der Wellenspannung gemessen. Ein Auswertesystem erstellt die Warnungen als eine Funktion der Veränderung des Wellenerdungsstromes, der Veränderung der Wellenspannung und dem durchschnittlichen Wellenerdungsstrom. Zudem offenbart diese Schrift, dass diese verschiedenen Messwerte in zeitlicher Abhängigkeit aufgezeichnet werden können.

EP 0 391 181 offenbart eine Anordnung zum Detektieren von Windungsschlüssen in der Rotorwicklung elektrischer Maschinen. Mit dieser Anordnung kann der Zustand einer elektrischen Maschine über einen längeren Zeitraum aufgezeichnet werden, es können aber auch einzelne Messungen durchgeführt werden. Hier wird die Wellenspannung zwischen Maschinenwelle und Erde erfasst. Als Auswertekriterium dienen die auftretenden Harmonischen der Wellenspannung. Bei einem windungsschlussfreien Rotor ist die Verteilung der Amperewindungen am Rotorumfang symmetrisch und das Rotorfeld der Maschine hat nur die ungeradzahligen Harmonischen. Tritt nun ein Windungsschluss auf, so beinhaltet das Rotorfeld auch die geradzahligen Harmonischen, da eine Asymmetrie in der Umfangsverteilung der Amperewindungen entsteht.

Ein weiteres dem Fachmann bekanntes Verfahren ist die Messung des Gleichspannungswiderstandes der Rotorwicklung im Betrieb. Mittels diesem Verfahren kann beispielweise die Temperatur in der Rotorwicklung gemessen werden. Hier wird jedoch nur der Wirkwiderstand bei Gleichspannung ermittelt.

Die EP 1 936 393 zeigt eine Vorrichtung zur Messung der Impedanz einer elektrischen Maschine zwischen der Maschine und der Erde unter der Verwendung von Testsignalen. Aufgrund der vielen Messung, welche an einer solchen Maschine ohnehin durchgeführt werden, hat die EP 1 936 393 im Wesentlichen den Nachteil, dass zusätzliche Testsignale eingesetzt werden, was die Anzahl der Signale erhöht und zu Unsicherheiten bzw. Fehlern in den Messungen führt.

Weiter zeigen JP11326469, EP 1 427 082, JP11083686 und US 5,689,194 verschiedene Messverfahren aus dem allgemeinen Stand der Technik.

### Darstellung der Erfindung

Ausgehend von diesem Stand der Technik liegt der Erfindung unter anderem die Aufgabe zugrunde, eine Vorrichtung sowie ein Verfahren zu schaffen, welche Fehlerzustände in einem Rotor, insbesondere in den Wicklungen eines Rotors, detektieren. Zudem soll aufgrund dieser Bestimmung beispielsweise auch der Zustand der Dämpferstäbe oder des Dämpferkäfigs des Rotors beurteilt werden können.

Es ist eine weitere Aufgabe der vorliegenden Erfindung, dass plötzliche Änderungen der Impedanz des Rotors erfasst werden können. Ausserdem sollen die plötzlichen Änderungen der Impedanz mit anderen Ereignissen korreliert werden.

Eine weitere Aufgabe der Erfindung ist es, dass andere Messungen nicht beeinflusst werden sollen.

Diese Aufgaben löst ein Verfahren mit den Merkmalen des Patentanspruchs 1. Das vorgeschlagene Verfahren dient zur Überwachung und/oder zur Analyse von elektrischen Maschinen im Betrieb, wobei die elektrische Maschine wenigstens einen Generator mit einer Welle, ein Erregersystem (zur Erzeugung des mit dem Rotor rotierenden Erregerfeldes, welches durch wenigstens eine Rotorwicklung generiert wird) sowie Antriebsmittel zum Antrieb dieser Welle umfasst.
Dabei wird ein erstes Signal, welches wenigstens mittelbar eine Spannung über einer Rotorwicklung beschreibt und ein zweites Signal, welches wenigstens mittelbar einen durch die Rotorwicklung fliessenden Strom beschreibt, simultan im Betrieb gemessen. Diese beiden Signale werden einer Analyseeinheit zugeführt. In der Analyseeinheit werden die Signale bevorzugtermaßen in einzelne Frequenzkomponenten aufgeteilt. Die aus diesen Signalen ermittelte Impedanz der Rotorwicklung wird anschließend zur Erkennung von Fehlerzuständen in der elektrischen Maschine verwendet. Die Abfolge der vorstehend beschriebenen Schritte kann auch eine andere sein.

Dies ist einer der Vorteile gegenüber dem Stand der Technik, denn so liegen beispielsweise zeitgerecht Ergebnisse betreffend Wechselstromverlusten im Rotor vor. Zudem können wichtige weitergehende Informationen, beispielsweise über den Zustand des Dämpferkäfigs, bereitgestellt werden. Ein weiterer Vorteil ist, dass sich die Impedanz bei Windungsschlüssen in einem grösseren Masse ändert als der Gleichspannungswiderstand der Rotorwicklung, welcher sich bei Windungsschlüssen nur weniger ändert.

Vorzugsweise werden das erste Signal und das zweite Signal über den elektrischen Leitern, welche die Schleifkontakte eines Erregersystems am Rotor mit der Erregermaschine verbinden, gemessen. Dies für die Situation, wo die Versorgung der Rotorwicklungen mit Strom respektive Spannung zur Erzeugung des Rotorfeldes über einen Kontakt (beispielsweise Kontaktbürsten) von einer externen, nicht rotierenden Versorgungseinheit, der Erregermaschine, auf den rotierenden Teil (Welle) übertragen wird und anschließend über auf oder in der Welle angeordnete Leiter mit den Rotorwicklungen verbunden ist.

Es ist eine weitere Aufgabe der vorliegenden Erfindung, Generatoren mit rotierender Erregereinrichtung bezüglich der Impedanz zu überwachen. Mit anderen Worten kann das vorgeschlagene Verfahren auch bei bürstenloser Erregung Anwendung finden, wo auf der Welle, vom eigentlichen Generator abgesetzt, auf dem Rotor eine rotierende Wicklung angeordnet ist, umgeben von einer Anordnung, welche ein statisches Feld zur Verfügung stellt. Die in dieser mit der Welle rotierenden Wicklung erzeugte Wechselspannung und Wechselstrom werden über einen auf der Welle angeordneten (und damit mitrotierenden) Gleichrichter gleichgerichtet und anschließend auf die eigentliche Rotorwicklung zur Erzeugung des Rotorfeldes übertragen.

Hierzu werden das erste Signal und das zweite Signal vorzugsweise im stationären Teil (d.h. in oder auf der Anordnung, welche ein statisches Feld zur Verfügung stellt) eines bürstenlosen Erregersystems gemessen.

Vorzugsweise können aber auch das erste Signal und das zweite Signal im rotierenden Teil eines bürstenlosen Erregersystems gemessen und mittels einer auf dem Rotor angeordneten Telemetrieeinheit von der Messstelle zu einer mit einer entsprechenden Empfängereinheit ausgebildeten Analyseeinheit drahtlos übermittelt werden. Die Überwachung der Verhältnisse im rotierenden System wird auf diese Weise überraschend vereinfacht, weil die Übermittlungseinheit, wenn sie kabellos ausgebildet ist, entsprechend genau wie die bürstenlose Erregung kontaktlos ausgebildet ist und somit sowohl hinsichtlich der Installation, der Wartung als auch des Betriebs wesentlich einfacher ist.

Die Signale können während des Betriebs der elektrischen Maschine erfasst werden. Die Drehzahl kann während des Betriebs konstant oder variabel sein.

Die Impedanz wird graphisch, insbesondere mittels einer Anzeigeeinheit, dargestellt. Eine Veränderung der Impedanz wird durch diese Darstellung sichtbar gemacht. So können Fehlerzustände erkannt und analysiert werden.

Zudem wird die Impedanz automatisch überwacht und ausgewertet, so dass Fehlerzustände automatisch erkannt werden können.

Die Darstellung bzw. die Analyse der Impedanz erfolgt in Abhängigkeit der Zeit und/oder der Frequenz.

Mittels dem Verfahren gemäss der vorliegenden Erfindung können diverse Fehlerzustände erkannt werden. Dabei handelt es sich bei den Fehlerzuständen z.B. um wenigstens einen Fehlerzustand ausgewählt aus der folgenden Gruppe:
Windungsschlüsse in der Rotorwicklung; Zustand der Dämpferstäbe; Zustand der Dämpferkäfige; torsionale Pendelungen, torsionale Vibrationen und/oder der Zustand des Stators.

Das Verfahren wird vorzugsweise mittels einer Vorrichtung gemäss Anspruch 8 umgesetzt.

### Kurze Beschreibung der Zeichnung

Die Erfindung wird im folgenden anhand der Zeichnung näher beschrieben. Es zeigen:

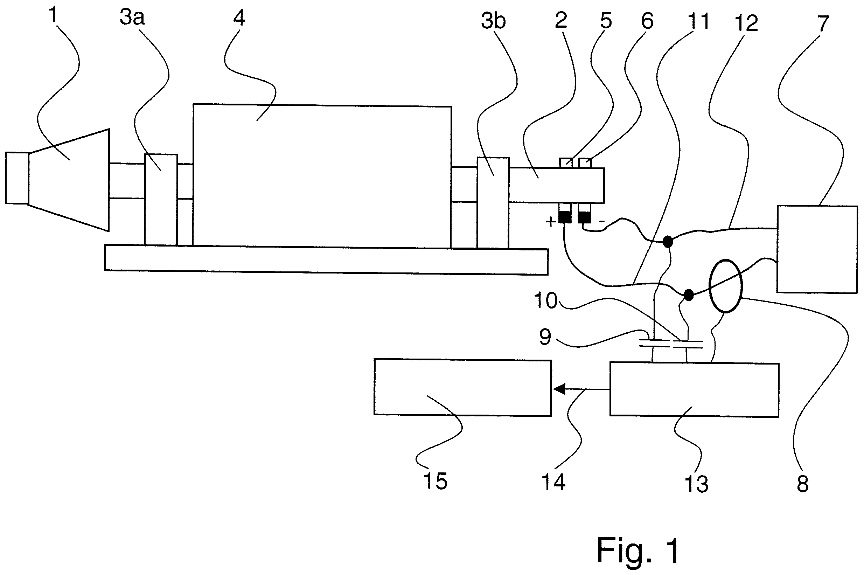

- Fig. 1: eine schematische Darstellung einer Vorrichtung zur Messung der Rotor-Wicklungsimpedanz einer elektrischen Maschine nach einer ersten Ausführungsform;
- Fig. 2: eine schematische Darstellung einer Vorrichtung zur Messung der Rotor-Wicklungsimpedanz einer elektrischen Maschine nach einer zweiten Ausführungsform;
- Fig. 3: eine schematische Darstellung einer Vorrichtung zur Messung der Rotor-Wicklungsimpedanz einer elektrischen Maschine nach einer dritten Ausführungsform; und
- Fig. 4: eine Darstellung eines beispielhaften Verlaufes der Erregerspannung und des Erregerstromes.

### Beschreibung eines Ausführungsbeispiels

Mit Bezug auf die Zeichnung wird ein mögliches Ausführungsbeispiel dargestellt. Die Zeichnung dient lediglich der Illustration des bevorzugten Ausführungsbeispiels und nicht zur Limitierung desselben oder der Ansprüche.

Die einzige Figur zeigt in schematischer Weise eine elektrische Maschine, bei welcher als Antriebsmittel eine Turbine 1 auf der einen Seite eines Generators 4 angeordnet ist, wobei die Turbine 1 und der Generator 4 mittels einer Welle 2 bzw. eines Wellenstranges verbunden sind. Die Welle 2 ist auf wenigstens zwei Lagern 3 gelagert, wobei ein erstes Lager 3a zwischen der Turbine 1 und dem Generator 4 angeordnet ist und ein zweites Lager 3b an der anderen Seite des Generators 4. Die beschriebene Anordnung ist beispielhaft zu verstehen. Es ist klar, dass beispielsweise an beiden Wellenenden eine Turbine angeordnet sein kann, und dass der Generator auch als Motor verwendet werden kann.

Die Rotorwicklung im Generator 4 wird durch ein Erregersystem 7 mit einer Erregermaschine über Bürstenkontakte am Rotor erregt. Das Erregersystem 7 ist vorzugsweise ein stellbarer Gleichrichter, welcher einen Wechselstrom in einen Gleichstrom umwandelt. Der Gleichstrom, auch als Erregerstrom bezeichnet, wird dann der Rotorwicklung über Kabel 11, 12 und Schleifringkontakte 5, 6 angelegt. Die Erregungsspannung und auch der Erregungsstrom liegen in pulsierender Form vor. Diese pulsierenden Signale können zur Bestimmung der Impedanz verwendet werden.

Die Schleifringkontakte 5, 6 sind auf der Welle 2 angeordnet. Im bevorzugten Ausführungsbeispiel ist im Bereich des Lagers 3b ein erster Schleifringkontakt 5 und ein zweiter Schleifringkontakt 6 angeordnet. Der Schleifringkontakt 5 ist der positive Pol und der Schleifringkontakt 6 der negative Pol.

Das Verfahren gemäss der vorliegenden Erfindung dient zur Bestimmung der Impedanz Z einer Rotorwicklung. Hierzu werden in einem ersten Schritt ein Signal S1 und ein Signal S2 erfasst.

Das Signal S1 ist die Spannung U, welche über der Rotorwicklung gemessen wird. Insbesondere wird der Wechselspannungsanteil dieser Rotorwicklungsspannung gemessen. Das Signal S2 ist der Strom I, welcher durch die Rotorwicklung fliesst. Insbesondere wird der Wechselstromanteil dieses Rotorwicklungsstromes I gemessen. Die Messung von S1 und S2 erfolgt simultan.

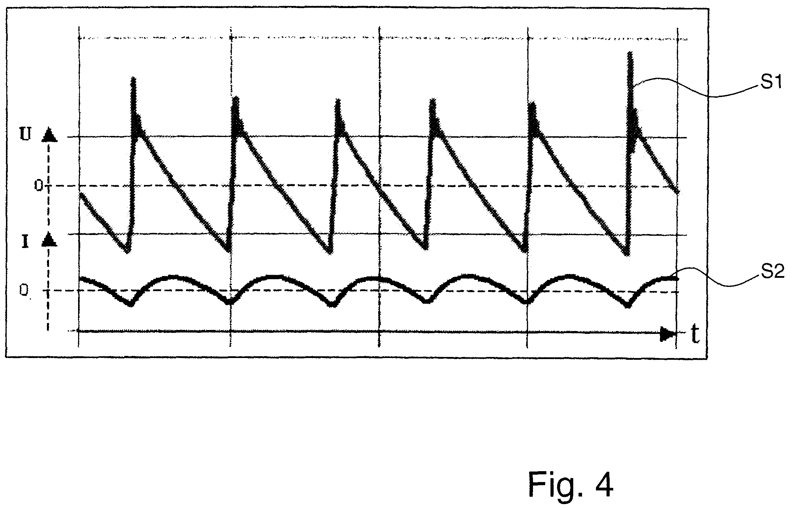

Die Figur 4 zeigt ein Beispiel der Erregerspannung I (S2) und des Erregerstromes U (S1) in Abhängigkeit von der Zeit t.
Die beiden Signale S1 und S2 werden dann einer Analyseeinheit 13 zugeführt und mittels dieser Analyseeinheit 13 in einzelne Frequenzkomponenten aufgeteilt. Vorzugsweise durch eine Fourier-Transformation. Anschliessend werden die einzelnen Frequenzkomponenten in an sich bekannter Art und Weise miteinander in Beziehung gesetzt, wobei insbesondere die Impedanz Z bestimmt wird.

Die Impedanz Z kann dann nach Betrag und Phase bzw. in komplexer Darstellung in Reaktanz und Resistanz bei verschiedenen Frequenzen mittels einer Anzeigeeinheit 15 dargestellt werden. Der Frequenzgang wird also nach Betrag und Phase ermittelt. Eine Veränderung der Impedanz Z wird durch diese Darstellung sichtbar. Dies erlaubt, dass Fehlerzustände erkannt bzw. analysiert werden können. Vorzugsweise wird die Impedanz Z in Abhängigkeit der Zeit t und/oder der Frequenz ν dargestellt.

Es ist zudem möglich, dass das Signal der Impedanz Z systematisch und automatisiert überwacht und ausgewertet wird, so dass Fehlerzustände schnell erkannt werden können.

Diese Messungen können entweder im stationären Betrieb erfolgen, also wenn die elektrische Maschine eine konstante Drehzahl aufweist oder aber auch im variablen Betrieb, also wenn die elektrische Maschine variable Drehzahlen aufweist. Insbesondere können Messungen beim Anfahren und beim Abfahren der elektrischen Maschine durchgeführt werden.

Die Rotorwicklungsspannung liegt in stark pulsierender Form an, insbesondere bei Anlagen mit statischen Erregungseinrichtungen. Der grosse höherfrequente Signalgehalt der pulsierenden Erregungsspannung erlaubt die Messung der Spannungsanteile U (z.B. DC=400V; AC=4000V) und der Stromanteile I (z.B. DC=2000A; AC=500mA) in einem weiten Frequenzbereich, typischerweise im Bereich von 1 Hz bis 200 kHz.

Durch die Bestimmung der Rotorwicklungsimpedanz Z können Änderungen elektrischer Eigenschaften des Rotors erfasst werden. Insbesondere hat das Verfahren den Vorteil, dass es bei höherfrequenten Signalen eingesetzt werden kann, denn gerade bei höherfrequenten Signalen machen sich Windungsschlüsse der Erregungswicklung und Unterbrüche im Dämpferkäfig verstärkt bemerkbar. Unter höherfrequenten Signalen sind Signale zu verstehen, die vorzugsweise eine Frequenz von ν = 150 Hz bis ν = 3000 Hz aufweisen.

Aufgrund der gemessenen Impedanz Z können Windungsschlüsse in der Rotorwicklung (die Reaktanz wird stark kleiner), der Zustand der Dämpferstäbe, der Zustand der Dämpferkäfige, torsionale Pendelungen oder torsionale Vibrationen erkannt werden.

Die Induktivität der Erregungswicklung ändert sich bei Windungsschlüssen weit stärker als der Gleichstromwiderstand der Spule. Dies ist ein Vorteil der vorliegenden Erfindung, denn so lassen sich Fehlerzustände genauer und sicherer bestimmen.

Die Kurzschlussschleife wirkt aufgrund der entmagnetisierenden Wirkung des Kurzschlussstromes feldvermindernd. Die Induktivität nimmt deshalb wesentlich stärker ab, im Vergleich zu einer Spule, die nur eine Windung weniger aufweist. Die Impedanz wird also resistiver.

Torsionale Pendelungen und torsionale Vibrationen des Maschinenrotors beeinflussen die ermittelte Impedanz aufgrund der Gegen-EMK der Impedanzeigenschaften der Rotorwicklung. Aufgrund dieser Beeinflussung können solche Pendelungen und Vibrationen ebenfalls erfasst werden.

Aufgrund der magnetischen Verkettung ist es zudem möglich, Rückschlüsse auf den magnetischen Zustand des Stators bzw. des magnetischen Gesamtkreises zu ziehen.
Die nach dem Verfahren der vorliegenden Erfindung gemessenen bzw. bestimmten Messwerte lassen sich auch über einen bestimmten Zeitraum aufzeichnen. Hierzu müssen entsprechende Mittel vorgesehen werden. Die Aufzeichnungen lassen eine spätere Auswertung zu und können zudem Hinweise für kommende Fehlerzustände liefern.

Dieses Verfahren wird vorzugsweise mit einer Vorrichtung gemäss der vorliegenden Erfindung umgesetzt.

Die Messvorrichtung gemäss der vorliegenden Erfindung umfasst vorzugsweise einen ersten Detektor, einen zweiten Detektor, eine Analyseeinheit 13, auch als Messdatenverarbeitungsvorrichtung bezeichnet, und ein Anzeigemittel 15.

Der erste Detektor ist galvanisch getrennt von der elektrischen Maschine angeordnet und misst ein erstes Signal S1. Wobei das erste Signal S1 eine Spannung U über einer Rotorwicklung beschreibt. Vorzugsweise umfasst der Detektor zwei Koppelkondensatoren 9, 10.

Der zweite Detektor ist galvanisch getrennt von der elektrischen Maschine angeordnet und misst ein zweites Signal S2, wobei das zweite Signal S2 einen durch die Rotorwicklung fliessenden Strom I beschreibt. Vorzugsweise umfasst der Detektor eine Spule 8.

Über die Kabel 11, 12 wird der Erregerstrom von der Erregermaschine 7 zu den Schleifkontakten 5, 6 geführt. Zudem sind die beiden Kabel 11, 12 über Koppel-Kondensatoren 9, 10 mit der Messdatenverarbeitungsvorrichtung 13 verbunden. Die Kondensatoren 9, 10 dienen zur Messung der Wechselspannungsanteile und weisen eine Kapazität von 1 nF bis 0,01 µF auf. Im Folgenden werden die Spannungsanteile mit U bezeichnet. Die gemessenen Spannungsanteile U werden als Signal S1 in die Messdatenverarbeitungsvorrichtung 13 geführt.

Das Kabel 11 wird durch die Spule 8 hindurchgeführt. Die Spule 8 ist vorzugsweise eine Messspule, besonders bevorzugt wird eine Rogovsky-Spule verwendet. Es ist aber auch möglich, dass das Kabel 12 durch die Spule 8 hindurchgeführt wird. Im Folgenden werden die Stromanteile mit I bezeichnet. Die gemessenen Stromanteile I werden als Signal S2 in die Messdatenverarbeitungsvorrichtung 13 geführt.

Die Messdatenverarbeitungsvorrichtung 13 dient zur Verarbeitung der gemessenen Stromanteile I und der gemessenen Spannungsanteile U. Vorzugsweise ist zudem ein Analog-Digital-Konverter vorgesehen, der die Signale S1 und S2 von einem analogen in ein digitales Signal umwandelt. Die Messdatenverarbeitungsvorrichtung 13 kann ein Messcomputer sein oder aber auch eine dafür ausgestaltete elektrische bzw. elektronische Vorrichtung. Die verarbeiteten Daten werden dann über die Anzeigeeinheit 15 dem Bedienpersonal der elektrischen Anlage angezeigt. Vorzugsweise werden die Daten in Abhängigkeit von der Zeit t oder der Frequenz ν dargestellt. Die Anzeigeeinheit 15 kann dabei ein handelsüblicher Bildschirm sein. Andere dem Fachmann bekannte Anzeigemittel können ebenfalls eingesetzt werden.

Vorteilhaft erfolgt die Messwertaufnahme galvanisch getrennt. Die Spannung U wird über Koppelkondensatoren 9, 10 kapazitiv abgegriffen und der Strom I wird über die Spule 8 induktiv abgegriffen. Dies erlaubt den Einsatz von hochspannungsfesten Bauteilen.

Die Koppelkondensatoren weisen vorzugsweise eine Kapazität von 1 nF bis 10 nF auf.

In einer weiteren, nicht gezeigten Ausführungsform sind Mittel bereitgestellt, um die Messdaten und/oder die verarbeiteten Daten über einen längeren Zeitraum zu speichern. Wobei unter einem längeren Zeitraum Tage, Monate oder gar Jahre zu verstehen sind.

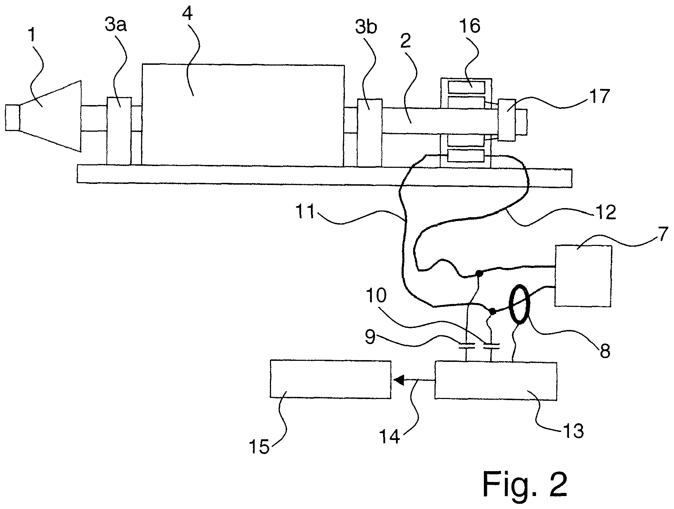

In einer weiteren Ausführungsform, welche in der Figur 2 dargestellt ist, werden die Signale S1 und S2 am stationären Teil eines bürstenlosen Erregersystems 16 gemessen. Das erste Signal S1 beschreibt eine Spannung U im stationären Teil des Erregersystems 16, und das zweite Signal S2 beschreibt einen Strom I im stationären Teil des Erregersystems 16. Mittels dieser beiden Signale lässt sich wiederum ein Impedanzwert berechnen, welcher einen Rückschluss auf hierin genannte Fehlerzustände zulässt. In der gezeigten Ausführungsform werden die beiden Signale über elektrische Leiter 11, 12, welche den stationären Teil des Erregersystems mit der Erregermaschine 7 verbinden, gemessen.

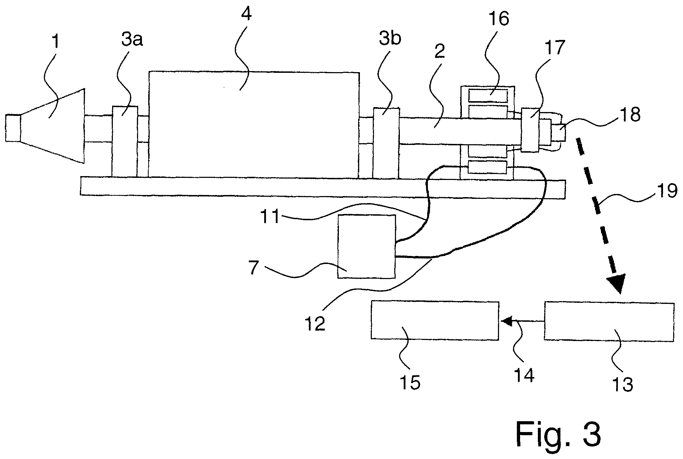

In einer weiteren Ausführungsform, welche in der Figur 3 gezeigt wird, werden die Signale S1 und S2 im Bereich des rotierenden Teiles des Erregersystems oder des Gleichrichters 18 erfasst. Dabei werden entsprechende Sensoren in diesen Bereichen angeordnet, so dass eine Spannung U und ein Strom I erfasst werden können. Die Signale S1 und S2 werden dann mittels einer Telemetrieeinheit, welche auf dem Rotor 2 fest angeordnet ist und mit diesem Rotor 2 rotiert, zu einer Empfängereinheit übermittelt, welche mit der Analyseeinheit 13 in Verbindung steht. Beispielsweise ist es denkbar, die Signale S1 und S2 über ein Funknetz oder ein drahtloses LAN zu übermitteln. Diese Ausführungsform hat den Vorteil, dass auch Störungen in der rotierenden Erregereinrichtung detektiert werden können, und dass keine Schleifkontakte vorgesehen werden müssen, um die Signale vom Rotor 2 wegzusenden. Dabei führen beispielsweise Fehler an den rotierenden Dioden, Sicherungen oder Wicklungsteilen zu einer Veränderung der Spannung U und/oder des Stromes I, was in einer Veränderung der Impedanz resultiert.

Alternativ kann die Analyseeinheit auch im Bereich der Sensoren bzw. in Bereich des Gleichrichters angeordnet sein, so dass die Funkverbindung direkt den Wert der Impedanz an eine Auswertungseinheit übermittelt.

### Bezugszeichenliste

- 1: Turbine, Antriebsmittel
- 2: Welle
- 3: Wellenlager
- 4: Generator
- 5: Schleifring (positiver Pol)
- 6: Schleifring (negativer Pol)
- 7: Erregersystem mit Bürsten
- 8: Spule, Rogovsky Spule
- 9: Kondensator
- 10: Kondensator
- 11: Kabel
- 12: Kabel
- 13: Analyseeinheit
- 14: Signalübertragungskabel für Resultate
- 15: Anzeigeeinheit, Trending System
- 16: bürstenloses Erregersystem
- 17: Gleichrichter
- 18: Sensoren
- 19: Funkverbindung

## Patentansprüche

1. Verfahren zur Überwachung und/oder Analyse von elektrischen Maschinen, wobei Fehlerzustände erkannt und/oder analysiert werden, wobei es sich bei den Fehlerzuständen um wenigstens einen Fehlerzustand, ausgewählt aus der folgenden Gruppe, handelt:
Windungsschlüsse in der Rotorwicklung; Zustand der Dämpferstäbe; Zustand der Dämpferkäfige; torsionale Pendelungen, torsionale Vibrationen und/oder Zustand des Stators, wobei die elektrische Maschine wenigstens einen Generator (4) mit einer Welle (2), ein Erregersystem (7) sowie Antriebsmittel (1) zum Antrieb dieser Welle (2) umfasst, wobei das Erregersystem (7) eine Spannung (U) und einen Strom (I) einer Rotorwicklung liefert, **dadurch gekennzeichnet, dass** ein erstes Signal (S1), welches wenigstens mittelbar die Spannung (U) über der Rotorwicklung beschreibt und ein zweites Signal (S2), welches wenigstens mittelbar den durch die Rotorwicklung fliessenden Strom (I) beschreibt, simultan im Betrieb von einem ersten Detektor bzw. einem zweiten Detektor gemessen werden, einer Analyseeinheit (13) zugeführt werden und in der Analyseeinheit (13) in einzelne Frequenzkomponenten aufgeteilt werden, und eine Bestimmung der Impedanz (Z) der Rotorwicklung bei verschiedenen Frequenzen (v) zur Erkennung von Fehlerzuständen in der elektrischen Maschine erfolgt, wobei der erste Detektor für die Messung der Spannung (U) Koppelkondensatoren (9, 10) umfasst, welche die Spannung (U) kapazitiv abgreifen, und der zweite Detektor für die Messung des Stromes (I) eine Rogovsky-Spule (8) umfasst, welche den Strom (I) induktiv abgreift, wobei das Verfahren bei einer Frequenz von *ν* = *150 Hz bis ν* = *3000* Hz verwendet wird, das erste Signal (S1) und das zweite Signal (S2) über elektrische Leiter (11, 12), welche die Schleifkontakte (5, 6) eines Erregersystems am Rotor mit der Erregermaschine (7) verbinden, gemessen werden oder das erste Signal (S1) und das zweite Signal (S2) im stationären Teil eines bürstenlosen Erregersystems (16) über elektrische Leiter (11, 12), welche den stationären Teil mit der Erregermaschine (7) verbinden, gemessen werden.

2. Verfahren nach Anspruch 1, **dadurch gekennzeichnet, dass** das erste Signal (S1) und das zweite Signal (S2) im rotierenden Teil eines bürstenlosen Erregersystems (16) gemessen werden und mittels einer auf dem Rotor (2) angeordneten Telemetrieeinheit von der Messstelle zu einer mit einer entsprechenden Empfängereinheit ausgebildeten Analyseeinheit drahtlos übermittelt werden.

3. Verfahren nach einem der vorhergehenden Ansprüche **dadurch gekennzeichnet, dass** die Signale (S1, S2) während des Betriebes der elektrischen Maschine erfasst werden, wobei die Drehzahl während des Betriebes der elektrischen Maschine konstant oder variabel ist.

4. Verfahren nach einem der vorhergehenden Ansprüche, **dadurch gekennzeichnet, dass** die Impedanz (Z) graphisch, insbesondere mittels einer Anzeigeeinheit (15), dargestellt wird, wobei eine Veränderung der Impedanz (Z) durch diese Darstellung sichtbar wird, so dass Fehlerzustände erkannt und/oder analysiert werden können.

5. Verfahren nach einem der vorhergehenden Ansprüche, **dadurch gekennzeichnet, dass** die Impedanz (Z) automatisch überwacht und ausgewertet wird, so dass Fehlerzustände automatisch erkannt werden können.

6. Verfahren nach einem der vorhergehenden Ansprüche, **dadurch gekennzeichnet, dass** die Impedanz (Z) in Abhängigkeit der Zeit (t) und/oder der Frequenz (v) dargestellt bzw. analysiert wird.

7. Verfahren nach einem der vorhergehenden Ansprüche, **dadurch gekennzeichnet, dass** nur die Wechselanteile der Spannung (U) und des Stromes (I) erfasst werden.

8. Vorrichtung zur Überwachung und/oder Analyse von einer elektrischen Maschine im Betrieb, wobei es sich bei den Fehlerzuständen um wenigstens einen Fehlerzustand, ausgewählt aus der folgenden Gruppe, handelt: Windungsschlüsse in der Rotorwicklung; Zustand der Dämpferstäbe; Zustand der Dämpferkäfige; torsionale Pendelungen, torsionale Vibrationen und/oder Zustand des Stators, wobei die elektrische Maschine wenigstens einen Generator (4) mit einer Welle (2), ein Erregersystem (7) sowie Antriebsmittel (1) zum Antrieb dieser Welle umfasst, **dadurch gekennzeichnet, dass** ein erster von der elektrischen Maschine galvanisch getrennter Detektor angeordnet ist, der ein erstes Signal (S1) misst, welches wenigstens mittelbar eine Spannung (U) über einer Rotorwicklung beschreibt und dass ein zweiter von der elektrischen Maschine galvanisch getrennter Detektor angeordnet ist, der ein zweites Signal (S2) misst, welches wenigstens mittelbar einen durch die Rotorwicklung fliessenden Strom (I) beschreibt, wobei der erste Detektor für die Messung der Spannung (U) Koppelkondensatoren (9, 10) umfasst, welche dazu eingerichtet sind, die Spannung (U) kapazitiv abzugreifen, und dass der zweite Detektor für die Messung des Stromes (I) eine Rogovsky-Spule (8) umfasst, welche dazu eingerichtet ist, den Strom (I) induktiv abzugreifen, und dass eine Analyseeinheit (13) angeordnet ist, welche die Signale (S1, S2) in einzelne Frequenzkomponenten aufteilt und die Impedanz (Z) der Rotorwicklung bei verschiedenen Frequenzen (v) bestimmt, wobei die Vorrichtung bei einer Frequenz von *ν* = *150 Hz bis ν* = *3000 Hz* verwendet wird, wobei das erste Signal (S1) und das zweite Signal (S2) über die elektrischen Leiter (11, 12), welche die Schleifkontakte (5, 6) am Rotor (2) mit der Erregermaschine (7) verbinden, messbar sind oder das erste Signal (S1) und das zweite Signal (S2) im stationären Teil, insbesondere über elektrische Leiter (11, 12), welche den stationären Teil mit der Erregermaschine (7) verbinden, eines bürstenlosen Erregersystems (16) messbar sind.

9. Vorrichtung nach Anspruch 8, **dadurch gekennzeichnet, dass** das erste Signal (S1) und das zweite Signal (S1) im rotierenden Teil eines bürstenlosen Erregersystems (16) messbar sind und mittels einer auf dem Rotor (2) angeordneten Telemetrieeinheit von der Messstelle zu einer mit einer entsprechenden Empfängereinheit ausgebildeten Analyseeinheit drahtlos übermittelbar sind.

10. Vorrichtung nach einem der Ansprüche 8 oder 9 **dadurch gekennzeichnet, dass** eine Anzeigeeinheit (15), insbesondere ein Bildschirm oder graphische Anzeigemittel, vorgesehen ist, durch welche die Impedanz (Z) graphisch anzeigbar ist, wobei insbesondere eine Veränderung der Impedanz (Z) durch diese Darstellung sichtbar wird, so dass Fehlerzustände analysierbar sind.

11. Vorrichtung nach einem der Ansprüche 8 bis 10, **dadurch gekennzeichnet, dass** die Detektoren dazu eingerichtet sind, nur die Wechselanteile der Spannung (U) und des Stromes (I) zu erfassen.

## Claims

1. Method for monitoring and/or analysing electrical machines, wherein the error status are identified and/or analysed, wherein the error statuses consist of at least one error status selected from the following group:
shorted coils in the rotor winding; status of the damper bars; status of the damper cages; torsional oscillations, torsional vibrations and/or status of the stator, wherein the electrical machine comprises at least one generator (4) with a shaft (2), an exciter (7) and a drive device (1) for driving said shaft (2), wherein the exciter (7) supplies a voltage (U) and a current (I) of a rotor winding, **characterised in that** a first signal (S1), which at least indirectly describes a voltage (U) across a rotor winding, and a second signal (S2), which at least indirectly describes a current (I) flowing through the rotor winding are measured simultaneously during operation by a first detector or a second detector, are supplied to an analysis unit (13) and are split in the analysis unit (13) into individual frequency components and the impedance (Z) of the rotor winding is determined at different frequencies (v) for the detection of error statuses in the electrical machine, wherein the first detector for measuring the voltage (U) comprises coupling capacitors (9, 10) for measuring the voltage (U), which capacitively tap off the voltage (U), and the second detector for measuring the current (I) comprises a Rogowski coil (8), which inductively taps off the current (I), wherein the method is used at a frequency of *v* = *150 Hz* to *v* = *3000 Hz,* the first signal (S1) and the second signal (S2) are measured via electrical conductors (11, 12) which connect sliding contacts (5, 6) of an exciter system on the rotor to the exciter (7), or the first signal (S1) and the second signal (S2) are measured in a stationary part of a brushless exciter system (16) via electrical conductors (11, 12) which connect the stationary part to the exciter (7).

2. Method according to claim 1, **characterised in that** the first signal (S1) and the second signal (S2) are measured in the rotating part of a brushless exciter system (16) and are transmitted wirelessly by a telemetry unit which is arranged on the rotor (2) from the measurement point to an analysis unit which is designed to have a corresponding receiver unit.

3. Method according to any of the preceding claims, **characterised in that** the signals (S1, S2) are recorded during the operation of the electrical machine, wherein the rotational speed is constant or variable during the operation of the electrical machine.

4. Method according to any of the preceding claims, **characterised in that** the impedance (Z) is displayed graphically, in particular by a display unit (15), wherein a change in the impedance (Z) can be visualised by said display so that error statuses can be identified and/or analysed.

5. Method according to any of the preceding claims, **characterised in that** the impedance (Z) is monitored automatically and evaluated so that error statuses can be identified automatically.

6. Method according to any of the preceding claims, **characterised in that** the impedance (Z) is displayed and analysed as a function of time (t) and/or frequency (v).

7. Method according to any of the preceding claims, **characterised in that** only the alternating components of the voltage (U) and of the current (I) are recorded.

8. Device for monitoring and/or analysing an electrical machine during operation, wherein error statuses consist of at least one error status selected from the following group: shorted coils in the rotor winding, status of the damper bars, status of the damper cages, torsional oscillations, torsional vibrations and/or status of the stator, wherein the electrical machine comprises at least one generator (4) with a shaft (2), an exciter (7) and a drive device (1) for driving said shaft, **characterised in that** a first detector is provided which is galvanically isolated from the electrical machine and measures a first signal (S1), which at least indirectly describes a voltage (U) across a rotor winding, and **in that** a second detector is provided which is galvanically isolated from the electrical machine and measures a second signal (S2), which at least indirectly describes a current (I) flowing through the rotor winding, wherein the first detector for measuring the voltage (U) comprises coupling capacitors (9, 10) which are configured to capacitively tap off the voltage (U), and the second detector for measuring the current (I) comprises a Rogowski coil (8), which is configured to inductively tap off the current (I) and an analysis unit (13) is provided, which splits the signals (S1, S2) into individual frequency components and determines the impedance (Z) of the rotor winding at different frequencies (v), wherein the device is used at a frequency of *v* = *150 Hz* to *v* = *3000 Hz,* wherein the first signal (S1) and the second signal (S2) can be measured via the electrical conductors (11, 12) which connect sliding contacts (5, 6) on the rotor (2) to the exciter (7), or the first signal (S1) and the second signal (S2) can be measured in the stationary part of a brushless exciter system (16), specifically via electrical conductors (11, 12) which connect the stationary part to the exciter (7).

9. Device according to claim 8, **characterised in that** the first signal (S1) and the second signal (S2) can be measured in the rotating part of a brushless exciter system (16) and can be transmitted wirelessly by means of a telemetry unit which is arranged on the rotor (2) from the measurement point to an analysis unit which is designed to have a corresponding receiver unit.

10. Device according to any of claims 8 or 9, **characterised in that** a display unit (15) is provided, in particular a screen or graphic display, by means of which the impedance (Z) can be displayed graphically, whereby specifically a change in the impedance (Z) can be visualised by the display, so that error statuses can be analysed.

11. Device according to any of claims 8 to 10, **characterised in that** the detectors are configured only to record alternating components of the voltage (U) and of the current (I).

## Revendications

1. Procédé de surveillance et/ou d'analyse de machines électriques, dans lequel des défauts sont détectés et/ou analysés, dans lequel les défauts sont au moins un défaut, choisi dans le groupe suivant :
courts-circuits dans l'enroulement de rotor; état des barres d'amortissement; état des cages d'amortissement ; mouvements pendulaires torsionnels, vibrations torsionnelles et/ou état du stator, dans lequel la machine électrique comprend au moins un générateur (4) avec un arbre (2), un système excitateur (7) ainsi que des moyens d'entraînement (1) destinés à l'entraînement de cet arbre (2), dans lequel le système excitateur (7) fournit une tension (U) et un courant (I) d'un enroulement de rotor, **caractérisé en ce qu'**un premier signal (S1), qui décrit au moins indirectement la tension (U) à l'enroulement de rotor, et un deuxième signal (S2), qui décrit au moins indirectement le courant (I) passant par l'enroulement de rotor, sont mesurés simultanément lors du fonctionnement respectivement par un premier détecteur et par un deuxième détecteur, sont envoyés à une unité d'analyse (13) et sont divisés dans l'unité d'analyse (13) en composantes fréquentielles individuelles et **en ce qu'**une détermination de l'impédance (Z) de l'enroulement de rotor s'effectue pour différentes fréquences (v) afin de détecter des défauts dans la machine électrique, dans lequel le premier détecteur pour la mesure de la tension (U) comprend des condensateurs de liaison (9, 10) qui prélèvent la tension (U) de manière capacitive et le deuxième détecteur pour la mesure du courant (I) comprend une bobine de Rogovski (8) qui prélève le courant (I) de manière inductive, dans lequel le procédé est utilisé pour une fréquence allant de *v* = *150 Hz* à *v* = *3 000* Hz, le premier signal (S1) et le deuxième signal (S2) sont mesurés via des conducteurs électriques (11, 12) qui relient les balais (5, 6) d'un système excitateur au niveau du rotor à la machine excitatrice (7) ou le premier signal (S1) et le deuxième signal (S2) sont mesurés dans la partie stationnaire d'un système excitateur sans balai (16) via des conducteurs électriques (11, 12) qui relient la partie stationnaire à la machine excitatrice (7).

2. Procédé selon la revendication 1, **caractérisé en ce que** le premier signal (S1) et le deuxième signal (S2) sont mesurés dans la partie en rotation d'un système excitateur sans balai (16) et sont transmis sans fil, au moyen d'une unité de télémétrie agencée sur le rotor (2), du point de mesure à une unité d'analyse réalisée avec une unité réceptrice correspondante.

3. Procédé selon l'une quelconque des revendications précédentes, **caractérisé en ce que** les signaux (S1, S2) sont détectés pendant le fonctionnement de la machine électrique, la vitesse de rotation pendant le fonctionnement de la machine électrique étant constante ou variable.

4. Procédé selon l'une quelconque des revendications précédentes, **caractérisé en ce que** l'impédance (Z) est représentée graphiquement, en particulier au moyen d'une unité d'affichage (15), une modification de l'impédance (Z) étant visible via cette représentation de sorte que des défauts peuvent être détectés et/ou analysés.

5. Procédé selon l'une quelconque des revendications précédentes, **caractérisé en ce que** l'impédance (Z) est surveillée et évaluée automatiquement de sorte que des défauts peuvent être détectés automatiquement.

6. Procédé selon l'une quelconque des revendications précédentes, **caractérisé en ce que** l'impédance (Z) est représentée ou analysée en fonction du temps (t) et/ou de la fréquence (v).

7. Procédé selon l'une quelconque des revendications précédentes, **caractérisé en ce que** seules les composantes alternatives de la tension (U) et du courant (I) sont détectées.

8. Dispositif de surveillance et/ou d'analyse d'une machine électrique en cours de fonctionnement, dans lequel les défauts sont au moins un défaut, choisi dans le groupe suivant : courts-circuits dans l'enroulement de rotor ; état des barres d'amortissement ; état des cages d'amortissement ; mouvements pendulaires torsionnels, vibrations torsionnelles et/ou état du stator, dans lequel la machine électrique comprend au moins un générateur (4) avec un arbre (2), un système excitateur (7) ainsi que des moyens d'entraînement (1) destinés à l'entraînement de cet arbre, **caractérisé en ce qu'**un premier détecteur séparé galvaniquement de la machine électrique est agencé, lequel mesure un premier signal (S1) qui décrit au moins indirectement une tension (U) à un enroulement de rotor, et **en ce qu'**un deuxième détecteur séparé galvaniquement de la machine électrique est agencé, lequel mesure un deuxième signal (S2) qui décrit au moins indirectement le courant (I) passant par l'enroulement de rotor, dans lequel le premier détecteur pour la mesure de la tension (U) comprend des condensateurs de liaison (9, 10) qui sont conçus pour prélever la tension (U) de manière capacitive et le deuxième détecteur pour la mesure du courant (I) comprend une bobine de Rogovski (8) qui est conçue pour prélever le courant (I) de manière inductive, et **en ce qu'**une unité d'analyse (13) est agencée, laquelle divise les signaux (S1, S2) en composantes fréquentielles individuelles et détermine l'impédance (Z) de l'enroulement de rotor pour différentes fréquences (v),
dans lequel le dispositif est utilisé pour une fréquence allant de *v* = *150 Hz à v* = *3 000 Hz,* dans lequel le premier signal (S1) et le deuxième signal (S2) peuvent être mesurés via les conducteurs électriques (11, 12) qui relient les balais (5, 6) au niveau du rotor (2) à la machine excitatrice (7) ou le premier signal (S1) et le deuxième signal (S2) peuvent être mesurés dans la partie stationnaire d'un système excitateur sans balai (16), en particulier via des conducteurs électriques (11, 12) qui relient la partie stationnaire à la machine excitatrice (7).

9. Dispositif selon la revendication 8, **caractérisé en ce que** le premier signal (S1) et le deuxième signal (S2) peuvent être mesurés dans la partie en rotation d'un système excitateur sans balai (16) et peuvent être transmis sans fil, au moyen d'une unité de télémétrie agencée sur le rotor (2), du point de mesure à une unité d'analyse réalisée avec une unité réceptrice correspondante.

10. Dispositif selon l'une quelconque des revendications 8 ou 9, **caractérisé en ce qu'**une unité d'affichage (15), en particulier un écran ou un moyen d'affichage graphique, est prévue, par lequel l'impédance (Z) peut être présentée graphiquement, une modification de l'impédance (Z) étant en particulier visible via cette représentation de sorte que des défauts peuvent être analysés.

11. Dispositif selon l'une quelconque des revendications 8 à 10, **caractérisé en ce que** les détecteurs sont conçus pour détecter seulement les composantes alternatives de la tension (U) et du courant (I).
